# EUROPEAN PATENT APPLICATION

(11) **EP 3 051 413 A1**
(43) Date of publication of application: **03.08.2016**
(21) Application number: 16152600.9
(22) Date of filing: 25.01.2016
(51) Int. Cl.: G06F 9/445, G06F 9/45

(54) **METHOD AND DEVICE FOR COMPRESSING FIRMWARE PROGRAM, METHOD AND DEVICE FOR DECOMPRESSING FIRMWARE PROGRAM**

(30) Priority: 29.01.2015 CN 201510044885
(71) Applicant: Xiaomi Inc., Beijing 100085 (CN)
(72) Inventor: MENG, Deguo, 100085 Haidian District (CN); LIU, Xin, 100085 Haidian District (CN); HOU, Enxing, 100085 Haidian District (CN)
(74) Representative: Sadler, Peter Frederick

(57) **Abstract**

The present disclosure provides a method and a device for compressing a firmware program, and a method and a device for decompressing a firmware program, which pertain to the field of computer technology. The method includes: acquiring (101) a code portion and a data portion of the firmware program; compressing (102) the code portion and the data portion separately; and configuring (103) first description data corresponding to the firmware program, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device.

## Description

### TECHNICAL FIELD

The present disclosure generally relates to the field of computer technology, and more particularly, to a method and a device for compressing a firmware program, and a method and a device for decompressing a firmware program.

### BACKGROUND

Firmware refers to software functioning at the bottom layer of an electronic device, to support the normal operation of the electronic device. Generally, the more functions that the electronic device has, the larger the firmware will be, and larger storage space will be required to store the firmware program.

In order to reduce the storage space occupied by the firmware program in the electronic device, in the related art, the firmware program as a whole will be compressed. Before it runs the firmware program, the electronic device decompresses the compressed firmware program. Then, based on a first decompression address corresponding to a decompressed code portion, the decompressed code portion of the firmware program is copied to the first decompression address; and based on a second decompression address corresponding to a decompressed data portion, the decompressed data portion is copied to the second decompression address.

### SUMMARY OF THE INVENTION

The present disclosure provides a method and a device for compressing a firmware program, and a method and a device for decompressing a firmware program. The technical solution is set out below.

According to a first aspect of embodiments of the present disclosure, there is provided a method for compressing a firmware program, including: acquiring a code portion and a data portion of the firmware program; compressing the code portion and the data portion separately; and configuring first description data corresponding to the firmware program, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device.

Optionally, acquiring a code portion and a data portion of the firmware program includes: determining a third storage address of the code portion and a fourth storage address of the data portion; and retrieving the code portion based on the third storage address and retrieving the data portion based on the fourth storage address.

Optionally, determining a third storage address of the code portion and a fourth storage address of the data portion includes: retrieving second description data corresponding to the firmware program; when the second description data contains the third storage address and the fourth storage address, determining the third storage address and the fourth storage address from the retrieved second description data; and when the second description data contains an original storage address of the code portion, a size of the code portion, an original storage address of the data portion, and a size of the data portion, determining the third storage address based on the retrieved original storage address of the code portion and the retrieved size of the code portion and determining the fourth storage address based on the retrieved original storage address of the data portion and the retrieved size of the data portion.

Optionally, configuring first description data corresponding to the firmware program includes: configuring a first storage address where the compressed code portion is stored in the electronic device and a second storage address where the compressed data portion is stored in the electronic device, taking the first storage address as the first address data, and taking the second storage address as the second address data; or configuring an original storage address of the compressed code portion in the electronic device and an original storage address of the compressed data portion in the electronic device, acquiring a size of the compressed code portion and a size of the compressed data portion; taking the original storage address of the compressed code portion and the size of the compressed code portion as the first address data; and taking the original storage address of the compressed data portion and the size of the compressed data portion as the second address data; and configuring the first decompression address and the second decompression address.

Optionally, configuring first description data corresponding to the firmware program also includes: acquiring a size of the code portion and a size of the data portion; and storing the size of the code portion and the size of the data portion into the first description data.

Optionally, compressing the code portion and the data portion separately, includes: dividing at least one of the code portion and the data portion; if the code portion is divided into a number m of segments, compressing the m segments of the code portion separately, and compressing the data portion; if the data portion is divided into a number n of segments, compressing the n segments of the data portion separately, and compressing the code portion; and if the code portion is divided into a number m of segments and the data portion is divided into a number n of segments, compressing the m segments of the code portion separately, and compressing the n segments of the data portion separately.

According to a second aspect of embodiments of the present disclosure, there is provided a method for decompressing a firmware program, including: retrieving first description data corresponding to the firmware program, the first description data containing first address data regarding where a compressed code portion of the firmware program is stored in an electronic device, second address data regarding where a compressed data portion of the firmware program is stored in the electronic device, a first decompression address where the compressed code portion is to be decompressed in the electronic device, and a second decompression address where the compressed data portion is to be decompressed in the electronic device; acquiring the compressed code portion based on the first address data, and acquiring the compressed data portion based on the second address data; and decompressing the compressed code portion to the first decompression address, and decompressing the compressed data portion to the second decompression address.

Optionally, acquiring the compressed code portion based on the first address data, and acquiring the compressed data portion based on the second address data includes: determining a first storage address based on the first address data and determining a second storage address based on the second address data; and retrieving the compressed code portion from the first storage address and retrieving the compressed data portion from the second storage address.

Optionally, determining a first storage address based on the first address data and determining a second storage address based on the second address data includes: if the first address data is the first storage address and the second address data is the second storage address, determining the first storage address and the second storage address based on the retrieved first description data; and if the first address data is an original storage address of the compressed code portion and a size of the compressed code portion, and the second address data is an original storage address of the compressed data portion and a size of the compressed data portion, determining the first storage address based on the original storage address and the size of the compressed code portion, and determining the second storage address based on the original storage address and the size of the compressed data portion.

Optionally, the first description data further contains a size of an uncompressed code portion of the firmware program and a size of an uncompressed data portion of the firmware program, and the method further includes: calculating a total size of the uncompressed code portion and the uncompressed data portion; examining whether the total size exceeds a space for running the firmware program in the electronic device; and if the total size exceeds a space for running the firmware program, prompting an error of the firmware program.

According to a third aspect of embodiments of the present disclosure, there is provided a device for compressing a firmware program, including: an acquiring module configured to acquire a code portion and a data portion of the firmware program; a compressing module configured to compress the code portion and the data portion separately; and a description-data configuring module configured to configure first description data corresponding to the firmware program, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device.

Optionally, the acquiring module includes: an address determining sub-module configured to determine a third storage address of the code portion and a fourth storage address of the data portion; and a retrieving sub-module configured to retrieve the code portion based on the third storage address and retrieve the data portion based on the fourth storage address.

Optionally, the address determining sub-module includes: a description-data retrieving unit configured to retrieve second description data corresponding to the firmware program; a first determining unit configured to, when the second description data contains the third storage address and the fourth storage address, determine the third storage address and the fourth storage address from the retrieved second description data; and a second determining unit configured to, when the second description data contains an original storage address of the code portion, a size of the code portion, an original storage address of the data portion, and a size of the data portion, determine the third storage address based on the retrieved original storage address of the code portion and the retrieved size of the code portion and determining the fourth storage address based on the retrieved original storage address of the data portion and the retrieved size of the data portion.

Optionally, the description-data configuring module includes: a first configuring sub-module configured to configure a first storage address where the compressed code portion is stored in the electronic device and a second storage address where the compressed data portion is stored in the electronic device, take the first storage address as the first address data, and take the second storage address as the second address data; or configuring an original storage address of the compressed code portion in the electronic device and an original storage address of the compressed data portion in the electronic device, acquiring a size of the compressed code portion and a size of the compressed data portion; taking the original storage address of the compressed code portion and the size of the compressed code portion as the first address data; and taking the original storage address of the compressed data portion and the size of the compressed data portion as the second address data; and a second configuring sub-module configured to configure the first decompression address and the second decompression address.

Optionally, the description-data configuring module also includes: a size acquiring sub-module configured to acquire a size of the code portion and a size of the data portion; and a size storing sub-module configured to store the size of the code portion and the size of the data portion into the first description data.

Optionally, the compressing module includes: a dividing sub-module configured to divide at least one of the code portion and the data portion; a first compressing sub-module configured to, if the code portion is divided into a number m of segments, compress the m segments of the code portion separately, and compress the data portion; a second compressing sub-module configured to, if the data portion is divided into a number n of segments, compress the n segments of the data portion separately, and compress the code portion; and a third compressing sub-module configured to, if the code portion is divided into a number m of segments and the data portion is divided into a number n of segments, compressing the m segments of the code portion separately, and compressing the n segments of the data portion separately.

According to a fourth aspect of embodiments of the present disclosure, there is provided a device for decompressing a firmware program, including: a description-data retrieving module configured to retrieve first description data corresponding to the firmware program, the first description data containing first address data regarding where a compressed code portion of the firmware program is stored in an electronic device, second address data regarding where a compressed data portion of the firmware program is stored in the electronic device, a first decompression address where the compressed code portion is to be decompressed in the electronic device, and a second decompression address where the compressed data portion is to be decompressed in the electronic device; an acquiring module configured to acquire the compressed code portion based on the first address data, and acquire the compressed data portion based on the second address data; and a decompressing module configured to decompress the compressed code portion to the first decompression address, and decompress the compressed data portion to the second decompression address.

Optionally, the acquiring module includes: an address determining sub-module configured to determine a first storage address based on the first address data and determine a second storage address based on the second address data; and a retrieving sub-module configured to retrieve the compressed code portion from the first storage address and retrieve the compressed data portion from the second storage address.

Optionally, the address determining sub-module includes: a first determining unit configured to, if the first address data is the first storage address and the second address data is the second storage address, determine the first storage address and the second storage address based on the retrieved first description data; and a second determining unit configured to, if the first address data is an original storage address of the compressed code portion and a size of the compressed code portion, and the second address data is an original storage address of the compressed data portion and a size of the compressed data portion, determine the first storage address based on the original storage address and the size of the compressed code portion, and determine the second storage address based on the original storage address and the size of the compressed data portion.

Optionally, the first description data further contains a size of an uncompressed code portion of the firmware program and a size of an uncompressed data portion of the firmware program, and the device further includes: a calculating module configured to calculate a total size of the uncompressed code portion and the uncompressed data portion; an examining module configured to examine whether the total size exceeds a space for running the firmware program in the electronic device; and a prompting module configured to, if the total size exceeds a space for running the firmware program, prompt an error of the firmware program.

The technical scheme according to embodiments of the present disclosure may have the following beneficial effects.

The code portion and the data portion of the firmware program are compressed separately; first description data corresponding to the firmware program is configured, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device. Thereby, when it needs to run the firmware program, the electronic device can directly acquire the compressed code portion and the compressed data portion based on the first description data, and respectively decompress the compressed code portion and the compressed data portion to the first decompression address and the second decompression address. Thus, it can solve the problem in the related art that after the firmware program is decompressed, the electronic device is required to copy the decompressed code portion and data portion, resulting in a complex process. Moreover, it can solve the problem that it is complicated to copy codes and the copy method has poor universality. Therefore, it can achieve an effect of reducing the complexity of the process of the electronic device by eliminating the need to copy codes.

It is to be understood that both the foregoing general description and the following detailed description are exemplary and explanatory only and are not restrictive of the invention, as defined by the claims.

### BRIEF DESCRIPTION OF THE DRAWINGS

The accompanying drawings, which are incorporated in and constitute a part of this specification, illustrate embodiments consistent with the invention and, together with the description, serve to explain the principles of the invention.
Fig. 1 is a flow chart showing a method for compressing a firmware program according to an exemplary embodiment.
Fig. 2A is a flow chart showing a method for compressing a firmware program according to another exemplary embodiment.
Fig. 2B is a flow chart showing a process for determining a third storage address and a fourth storage address according to another exemplary embodiment.
Fig. 2C is a flow chart showing a process for configuring first description data according to another exemplary embodiment.
Fig. 2D is a flow chart showing another process for configuring first description data according to another exemplary embodiment.
Fig. 2E is a flow chart showing a possible process for compressing a code portion and a data portion according to another exemplary embodiment.
Fig. 3 is a flow chart showing a method for decompressing a firmware program according to an exemplary embodiment.
Fig. 4A is a flow chart showing a method for decompressing a firmware program according to another exemplary embodiment.
Fig. 4B is a flow chart showing a process for determining a first storage address and a second storage address according to another exemplary embodiment.
Fig. 4C is a flow chart showing a process for examining an error of the firmware program according to another exemplary embodiment.
Fig. 5 is a block diagram of a device for compressing a firmware program according to an exemplary embodiment.
Fig. 6A is a block diagram of a device for compressing a firmware program according to another exemplary embodiment.
Fig. 6B is a block diagram of an address determining sub-module according to another exemplary embodiment.
Fig. 6C is a block diagram of a compressing module according to another exemplary embodiment.
Fig. 7 is a block diagram of a device for decompressing a firmware program according to an exemplary embodiment.
Fig. 8A is a block diagram of a device for decompressing a firmware program according to another exemplary embodiment.
Fig. 8B is a block diagram of an address determining sub-module according to another exemplary embodiment.
Fig. 9 is a block diagram of a device for compressing a firmware program according to an exemplary embodiment.
Fig. 10 is a block diagram of a device for decompressing a firmware program according to an exemplary embodiment.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

Firstly, for easy understanding, the terms used in the embodiments are briefly explained.

A code portion, also referred to as *txt* segment, contains therein executable codes of a firmware program.

A data portion contains therein global static data required in running of codes of a firmware program.

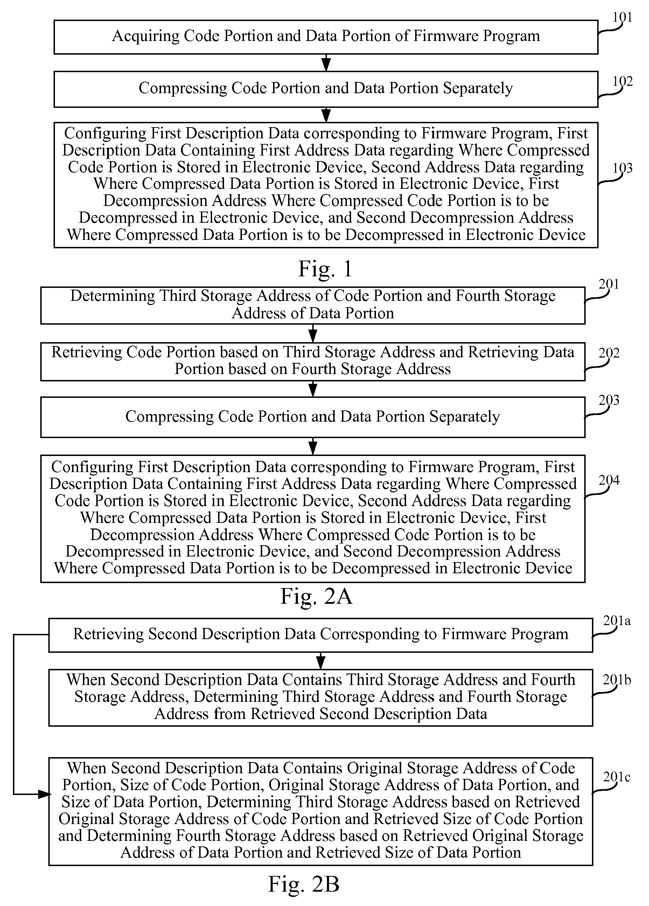

Fig. 1 is a flow chart showing a method for compressing a firmware program according to an exemplary embodiment. As shown in Fig. 1, the method for compressing a firmware program can include the following steps.

In step 101, a code portion and a data portion of the firmware program are acquired.

In step 102, the code portion and the data portion are compressed separately.

In step 103, first description data corresponding to the firmware program is configured, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device.

Accordingly, in the method for compressing a firmware program provided in the embodiment of the present disclosure, the code portion and the data portion of the firmware program are compressed separately; first description data corresponding to the firmware program is configured, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device. Thereby, when it needs to run the firmware program, the electronic device can directly acquire the compressed code portion and the compressed data portion based on the first description data. The first description data may be stored at and retrieved from memory associated with the electronic device, having been received from a server or preinstalled at the electronic device. The electronic device can respectively decompress the compressed code portion and the compressed data portion to the first decompression address and the second first decompression address. Thus, it can solve the problem in the related art that after the firmware program is decompressed, the electronic device is required to copy the decompressed code portion and data portion, resulting in a complex process. Moreover, it can solve the problem that it is complicated to copy codes and the copy method has poor universality. Therefore, it can achieve an effect of reducing the complexity of the process of the electronic device by eliminating the need to copy codes.

Fig. 2A is a flow chart showing a method for compressing a firmware program according to an exemplary embodiment. As shown in Fig. 2A, the method for compressing a firmware program can include the following steps.

In step 201, a third storage address of the code portion and a fourth storage address of the data portion are determined.

If the firmware program is stored in a server, and includes a code portion and a data portion, when it needs to compress the firmware program the server can determine a third storage address of the code portion in the server and a fourth storage address of the data portion in the server.

Referring to Fig. 2B, the present step can include the following steps.

In step 201a, second description data corresponding to the firmware program is retrieved.

The server can store a store second description data corresponding to a firmware program together with the stored firmware program. The second description data can contain the third storage address and the fourth storage address, or it can contain an original storage address of the code portion, a size of the code portion, an original storage address of the data portion, and a size of the data portion. Thus, the server can determine the third storage address and the fourth storage address by retrieving the second description data.

In step 201b, when the second description data contains the third storage address and the fourth storage address, the third storage address and the fourth storage address are determined from the retrieved second description data.

In step 201c, when the second description data contains an original storage address of the code portion, a size of the code portion, an original storage address of the data portion, and a size of the data portion, the third storage address is determined based on the retrieved original storage address of the code portion and the retrieved size of the code portion and the fourth storage address is determined based on the retrieved original storage address of the data portion and the retrieved size of the data portion.

For example, if the second description data contains an original storage address D1 of the code portion, and the code portion has size S1 requiring a storage space d1, the third storage address can be determined as D1 to D1+d1.

In step 202, the code portion is retrieved based on the third storage address and the data portion is retrieved based on the fourth storage address.

After it determines the third storage address and the fourth storage address, the server can retrieve the code portion from the third storage address and retrieve the data portion from the fourth storage address.

For example, the server can retrieve the code portion from the address D1 to D1+d1.

In step 203, the code portion and the data portion are compressed separately.

The server compresses the retrieved code portion and compresses the retrieved data portion.

In step 204, first description data corresponding to the firmware program is configured, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device.

After it compresses the code portion and the data portion separately, the server can configure a corresponding first description data.

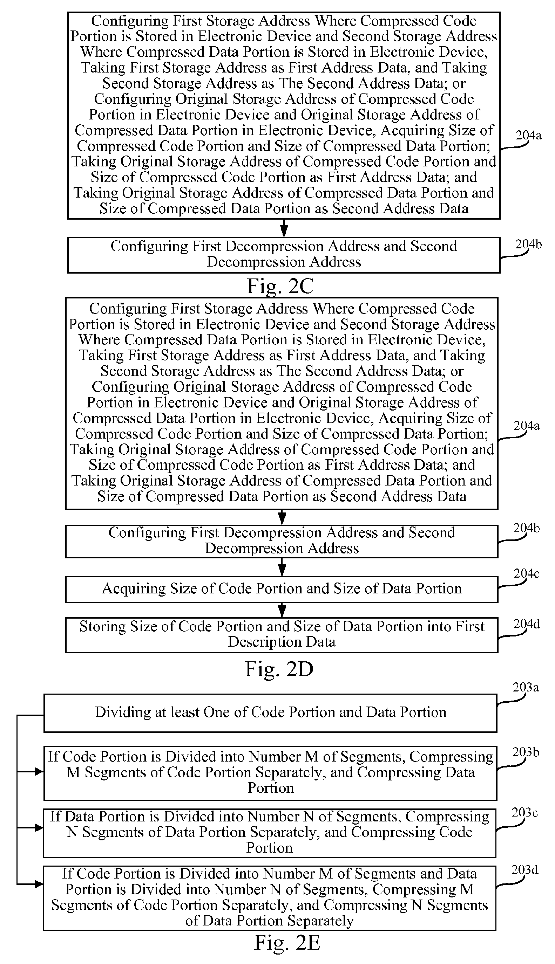

Referring to Fig. 2C, the present step can include the following steps.

In step 204a, a first storage address where the compressed code portion is stored in the electronic device and a second storage address where the compressed data portion is stored in the electronic device are configured, the first storage address is taken as the first address data, and the second storage address is taken as the second address data; or, an original storage address of the compressed code portion in the electronic device and an original storage address of the compressed data portion in the electronic device are configured, a size of the compressed code portion and a size of the compressed data portion are acquired; the original storage address of the compressed code portion and the size of the compressed code portion are taken as the first address data; and the original storage address of the compressed data portion and the size of the compressed data portion are taken as the second address data.

Since a firmware program is typically adapted to an electronic device of a designated type and the electronic device typically has a certain storage space, the server can configure a first storage address where the compressed code portion is stored in the electronic device and a second storage address where the compressed data portion is stored in the electronic device, take the first storage address as the first address data, and take the second storage address as the second address data. Wherein, the server can configure a first storage address where the compressed code portion is stored in Flash memory of the electronic device and a second storage address where the compressed data portion is stored in the Flash memory of the electronic device

Alternatively, the server can only configure an original storage address of the compressed code portion in the electronic device and an original storage address of the compressed data portion in the electronic device; then acquire respectively a size of the compressed code portion and a size of the compressed data portion; and finally, take the original storage address of the compressed code portion in the electronic device and the size of the compressed code portion as the first address data; and take the original storage address of the compressed data portion in the electronic device and the size of the compressed data portion as the second address data.

In step 204b, the first decompression address and the second decompression address are configured.

Since a firmware program is typically adapted to an electronic device of a designated type and the electronic device typically has a certain storage space, the server can configure in advance a first decompression address in the electronic device which corresponds to the compressed code portion and a second decompression address in the electronic device which corresponds to the compressed data portion.

It should be noted that, in the present embodiment, as an example, the step 204a is performed before the step 204b. Optionally, the server can perform the step 204a and the step 204b simultaneously, or perform the step 204b before the step 204a, which is not limited in the present embodiment.

It should be further noted that, in the present embodiment, as an example, the first description data is configured separately. Optionally, the server can also configure the contents of the first description data in the second description data. This is not limited in the present disclosure.

Accordingly, in the method for compressing a firmware program provided in the embodiment of the present disclosure, the code portion and the data portion of the firmware program are compressed separately; first description data corresponding to the firmware program is configured, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device. Thereby, when it needs to run the firmware program, the electronic device can directly acquire the compressed code portion and the compressed data portion based on the first description data, and respectively decompress the compressed code portion and the compressed data portion to the first decompression address and the second first decompression address. Thus, it can solve the problem in the related art that after the firmware program is decompressed, the electronic device is required to copy the decompressed code portion and data portion, resulting in a complex process. Moreover, it can solve the problem that it is complicated to copy codes and the copy method has poor universality. Therefore, it can achieve an effect of reducing the complexity of the process of the electronic device by eliminating the need to copy codes.

In the present embodiment, the code portion and the data portion of the firmware program are compressed separately, thereby the electronic device can directly decompress the compressed code portion to the first decompression address, and directly decompress the compressed data portion to the second decompression address, rather than decompressing the firmware program as a whole and then copying it to a corresponding decompression address. Thus, it can eliminate the need to reserve a space in the memory of the electronic device to store the decompressed firmware program and can improve the utilization of the space of the memory of the electronic device.

It should be noted that, as shown in Fig. 2D, in the above embodiments, the step of the server configuring the first description data corresponding to the firmware program further includes the following steps.

In step 204c, a size of the code portion and a size of the data portion are acquired.

The server can also acquire a size of the uncompressed code portion and a size of the uncompressed data portion.

Optionally, when both of the sizes are contained in the second description data, the server can retrieve the above contents from the second description data.

When the second description data contains the third storage address of the code portion and the fourth storage address of the data portion, the server can determine the size of the code portion from the range of the third storage address, and determine the size of the data portion from the range of the fourth storage address. This is not limited in the present embodiment.

In step 204d, the size of the code portion and the size of the data portion are stored in the first description data.

The server can store in the first description data the size of the code portion and the size of the data portion as acquired.

However, if the contents of the first description data are directly configured in the second description data, the server can store in the second description data the size of the code portion and the size of the data portion as acquired. This is not limited in the present embodiment. In addition, if the second description data already contains both the above sizes, the server can skip the step 204c and the step 204d. This is also not limited in the present embodiment.

Further, in the present embodiment, the performing sequence of the step 204a, the step 204b and the step 204c is not limited, and the server can perform the steps according to other sequences depending on the practical application.

It should be further noted that, in the above embodiment, as shown in Fig. 2E, the step 203 can include the following steps.

In step 203a, at least one of the code portion and the data portion is divided.

After it acquires the code portion and the data portion of the firmware program, the server can divide the code portion or the data portion, or can divide both of them.

For example, the server divides the code portion and it can divide the code portion into a number *m* segments.

Optionally, after the dividing, each segment of the code portion can have the same length or different lengths. Similarly, after the dividing, each segment of the data portion can have the same length or different lengths.

In step 203b, if the code portion is divided into a number *m* of segments, the *m* segments of the code portion are compressed separately, and the data portion is compressed.

If the server divides the code portion into a number *m* segments, the server can compress the *m* segments of the code portion separately, and further compress the data portion.

Correspondingly, the first address data configured by the server can include address data of each of the *m* compressed segments in the electronic device, and the first decompressed address configured by the server includes a decompression address corresponding to each of the *m* compressed segments in the electronic device.

In step 203c, if the data portion is divided into a number *n* segments, *the n* segments of the data portion are compressed separately, and the code portion is compressed.

If the server divides the data portion into a number *n* segments, the server can compress the *n* segments of the data portion separately, and compress the code portion.

Correspondingly, the second address data configured by the server can include address data of each of the *n* compressed segments in the electronic device, and the second decompressed address configured by the server includes a decompression address corresponding to each of the *n* compressed segments in the electronic device.

In step 203d, if the code portion is divided into a number *m* segments and the data portion is divided into a number *n* segments, the *m* segments of the code portion are compressed separately, and the *n* segments of the data portion are compressed separately.

Similarly, if it divides the code portion into a number *m* of segments and divides the data portion into a number *n* of segments, the server can compress the *m* segments of the divided code portion separately and compress the *n* segments of the divided data portion separately.

Correspondingly, in this case, the first address data configured by the server can include address data of each of the *m* compressed segments in the electronic device; the first decompressed address configured by the server includes a decompression address corresponding to each of the *m* compressed segments in the electronic device; the second address data configured by the server can include address data of each of the *n* compressed segments in the electronic device; and the second decompressed address configured by the server includes a decompression address corresponding to each of the n compressed segments in the electronic device.

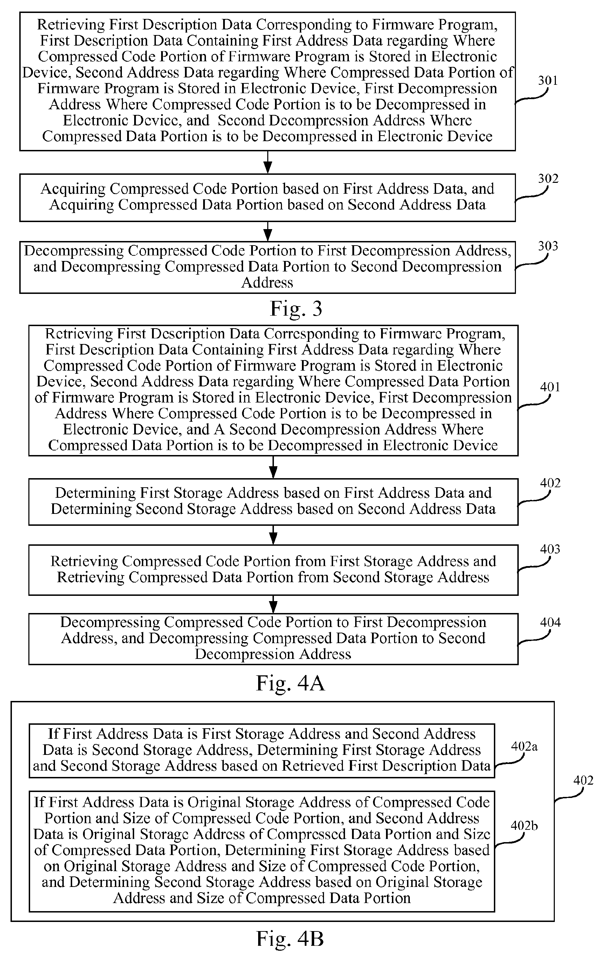

Fig. 3 is a flow chart showing a method for decompressing a firmware program according to an exemplary embodiment. As shown in Fig. 3, the method for decompressing a firmware program can include the following steps.

In step 301, first description data corresponding to the firmware program is retrieved, the first description data containing first address data regarding where a compressed code portion of the firmware program is stored in an electronic device, second address data regarding where a compressed data portion of the firmware program is stored in the electronic device, a first decompression address where the compressed code portion is to be decompressed in the electronic device, and a second decompression address where the compressed data portion is to be decompressed in the electronic device.

In step 302, the compressed code portion is acquired based on the first address data, and the compressed data portion is acquired based on the second address data.

In step 303, the compressed code portion is decompressed to the first decompression address, and the compressed data portion is decompressed to the second decompression address.

Accordingly, in the method for decompressing a firmware program provided in the embodiment of the present disclosure, first description data is retrieved, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device; the compressed code portion is acquired based on the retrieved first address data, and the compressed data portion is acquired based on the retrieved second address data; the compressed code portion is decompressed to the first decompression address, and the compressed data portion is decompressed to the second decompression address. Thereby, it can solve the problem in the related art that after the firmware program is decompressed, the electronic device is required to copy the decompressed code portion and data portion, resulting in a complex process. Moreover, it can solve the problem that it is complicated to copy codes and the copy method has poor universality. Therefore, it can achieve an effect of reducing the complexity of the process of the electronic device by eliminating the need to copy codes.

Fig. 4A is a flow chart showing a method for decompressing a firmware program according to an exemplary embodiment. As shown in Fig. 4A, the method for decompressing a firmware program can include the following steps.

In step 401, first description data corresponding to the firmware program is retrieved, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device.

The electronic device can acquire the firmware program from the server over a network, or, the electronic device can acquire the firmware program from a recovery device or a mobile storage device. The firmware program is typically a compressed firmware program, and typically includes a compressed code portion, a compressed data portion and first description data. The first description data contains first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device. In addition, the firmware program in the recovery device or the mobile storage device can be firmware program acquired in advance from a server. This is not limited in the present embodiment.

When it needs to run the firmware program, the electronic device can retrieve the first description data.

In step 402, a first storage address is determined based on the first address data and a second storage address is determined based on the second address data.

After the first address data and the second address data are retrieved from the first description data, the electronic device can determine a first storage address based on the first address data and determine a second storage address based on the second address data.

Referring to Fig. 4B, the present step can include:

In step 402a, if the first address data is the first storage address and the second address data is the second storage address, the first storage address and the second storage address are determined based on the retrieved first description data.

In step 402b, if the first address data is an original storage address of the compressed code portion and a size of the compressed code portion, and the second address data is an original storage address of the compressed data portion and a size of the compressed data portion, the first storage address is determined based on the original storage address and the size of the compressed code portion, and the second storage address is determined based on the original storage address and the size of the compressed data portion.

The present step is similar to the step 201c in the above embodiment, which will not be repeated in the present embodiment.

In step 403, the compressed code portion is retrieved from the first storage address and the compressed data portion is retrieved from the second storage address.

In step 404, the compressed code portion is decompressed to the first decompression address, and the compressed data portion is decompressed to the second decompression address.

After it retrieves the compressed code portion and the compressed data portion, the electronic device can decompress the compressed code portion to the first decompression address, and decompress the compressed data portion to the second decompression address.

After it decompresses the compressed code portion and the compressed data portion, the electronic device can turn to the beginning of the code portion to run the code portion.

Accordingly, in the method for decompressing a firmware program provided in the embodiment of the present disclosure, first description data is retrieved, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device; the compressed code portion is acquired based on the retrieved first address data, and the compressed data portion is acquired based on the retrieved second address data; the compressed code portion is decompressed to the first decompression address, and the compressed data portion is decompressed to the second decompression address. Thereby, it can solve the problem in the related art that after the firmware program is decompressed, the electronic device is required to copy the decompressed code portion and data portion, resulting in a complex process. Moreover, it can solve the problem that it is complicated to copy codes and the copy method has poor universality. Therefore, it can achieve an effect of reducing the complexity of the process of the electronic device by eliminating the need to copy codes.

In the present embodiment, the code portion and the data portion of the firmware program are compressed separately, thereby the electronic device can directly decompress the compressed code portion to the first decompression address, and directly decompress the compressed data portion to the second decompression address, rather than decompressing the firmware program as a whole and then copying it to a corresponding decompression address. Thus, it can eliminate the need to reserve a space in the memory of the electronic device to store the decompressed firmware program and can improve the utilization of the space of the memory of the electronic device.

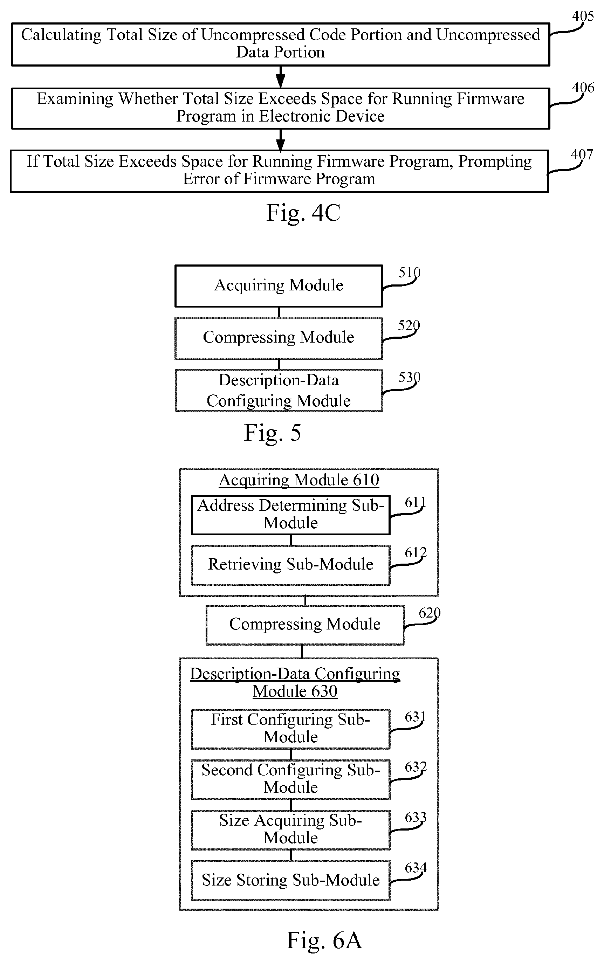

It should be noted that, as shown in Fig. 4C, in the above embodiment, the first description data can also contain a size of an uncompressed code portion and a size of an uncompressed data portion, and the method further includes the following steps.

In step 405, a total size of the uncompressed code portion and the uncompressed data portion is calculated.

When the first description data also contains a size of the uncompressed code portion and a size of the uncompressed data portion, after it retrieves the first description data, the electronic device can calculate a sum of the size of the uncompressed code portion and the size of the uncompressed data portion, to obtain a total size of the uncompressed code portion and the uncompressed data portion.

In step 406, it is examined whether the total size exceeds a space for running the firmware program in the electronic device.

It is examined whether the calculated total size exceeds a preserved space for running the firmware program in the electronic device. The space for running the firmware program refers to a memory space preserved by the electronic device for running the firmware program.

In step 407, if the total size exceeds a space for running the firmware program, an error of the firmware program is prompted.

If the electronic device examines that the total size exceeds the space for running the firmware program, it means that the firmware program is not adapted for the electronic device of such type, and then, the electronic device can prompt an error of the firmware program.

It should be noted that the above steps are generally performed before the step 404. If it is examined that the total size exceeds the space for running the firmware program, the electronic device will not perform the step 404, and only when it is examined that the total size does not exceed the space for running the firmware program, the electronic device will perform the step 404. This is not limited in the present embodiment.

In the present embodiment, the total size of the code portion and the data portion are calculated, thereby the user can be prompted if the firmware program has an error.

It should be further noted that the step 402 can include the following steps.

If the first address data contains address data of each of the *m* compressed segments, the electronic device can determine a storage address of each segment based on the address data of the segment. That is to say, the first storage address contains the storage data of each of the *m* compressed segments in the electronic device.

Subsequently, the electronic device can retrieve a code segment stored at each storage address, and decompress the retrieved code segment to a decompression address in the first decompression address which corresponds to this code segment. For example, for an *i*-th code segment of the *m* segments, based on address data of the *i*-th code segment in the first address data, the electronic device can determine the storage address of the *i*-th code segment, then retrieve the *i*-th code segment from the storage address of the *i*-th code segment, and decompress the retrieved *i*-th code segment to a decompression address in the first decompression address which corresponds to the *i*-th code segment.

Similarly, if the second address data contains address data of each of *the n* segments of the compressed data portion, the electronic device can determine a storage address of each segment based on the address data of the segment. That is to say, the second storage address contains the storage data of each of the *n* compressed segments in the electronic device.

Subsequently, the electronic device can retrieve a data segment stored at each storage address, and decompress the retrieved data segment to a decompression address in the second decompression address which corresponds to this data segment. This is similar to the process of the *m* segments of the compressed code portion, which will not be repeated in the present embodiment.

It should be further noted that, in the above embodiments, the compressed firmware program as stored includes a code portion, a data portion and description data. The description data contains first address data for the compressed code portion of the firmware program, second address data for the compressed data portion of the firmware program, a first decompression address corresponding to the compressed code portion, and a second decompression address corresponding to the compressed data portion. Optionally, the description data can also contain a size of the uncompressed code portion and a size of the uncompressed data portion. However, the description data can also contain other information, which is not limited in the present embodiment.

In the following embodiments of devices according to the present disclosure, the devices can be configured to perform the method in the above embodiments of the present disclosure. Details are not disclosed in the embodiments of devices can be referred to the embodiments of methods.

Fig. 5 is a block diagram of a device for compressing a firmware program according to an exemplary embodiment. As shown in Fig. 5, the device for compressing a firmware program can include but is not limited to: an acquiring module 510, a compressing module 520 and a description-data configuring module 530.

The acquiring module 510 is configured to acquire a code portion and a data portion of the firmware program; the compressing module 520 is configured to compress the code portion and the data portion separately; and the description-data configuring module 530 is configured to configure first description data corresponding to the firmware program, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device.

Accordingly, in the device for compressing a firmware program provided in the embodiment of the present disclosure, the code portion and the data portion of the firmware program are compressed separately; first description data corresponding to the firmware program is configured, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device. Thereby, when it needs to run the firmware program, the electronic device can directly acquire the compressed code portion and the compressed data portion based on the first description data, and respectively decompress the compressed code portion and the compressed data portion to the first decompression address and the second decompression address. Thus, it can solve the problem in the related art that after the firmware program is decompressed, the electronic device is required to copy the decompressed code portion and data portion, resulting in a complex process. Moreover, it can solve the problem that it is complicated to copy codes and the copy method has poor universality. Therefore, it can achieve an effect of reducing the complexity of the process of the electronic device by eliminating the need to copy codes.

Fig. 6A is a block diagram of a device for compressing a firmware program according to an exemplary embodiment. As shown in Fig. 6A, the device for compressing a firmware program can include but is not limited to: an acquiring module 610, a compressing module 620 and a description-data configuring module 630.

The acquiring module 610 is configured to acquire a code portion and a data portion of the firmware program; the compressing module 620 is configured to compress the code portion and the data portion separately; and the description-data configuring module 630 is configured to configure first description data corresponding to the firmware program, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device.

Optionally, the acquiring module 610 includes: an address determining sub-module 611 configured to determine a third storage address of the code portion and a fourth storage address of the data portion; and a retrieving sub-module 612 configured to retrieve the code portion based on the third storage address and retrieve the data portion based on the fourth storage address.

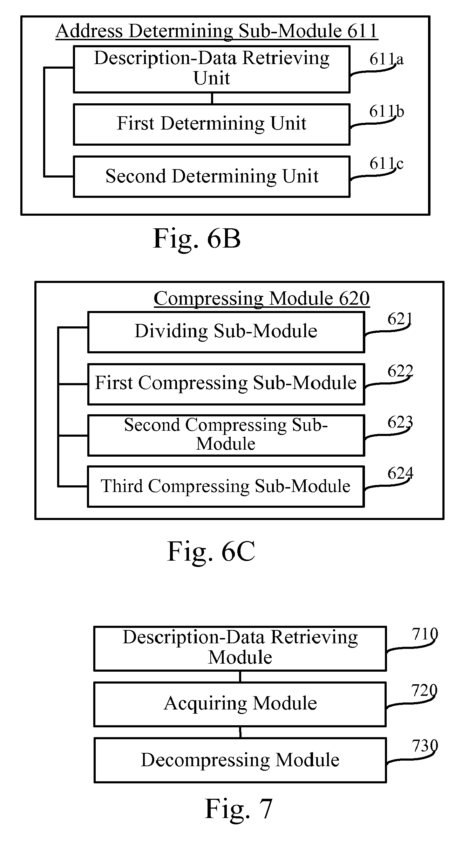

Optionally, as shown in Fig. 6B, the address determining sub-module 611 includes: a description-data retrieving unit 611a configured to retrieve second description data corresponding to the firmware program; a first determining unit 611b configured to, when the second description data contains the third storage address and the fourth storage address, determine the third storage address and the fourth storage address from the retrieved second description data; and a second determining unit 611c configured to, when the second description data contains an original storage address of the code portion, a size of the code portion, an original storage address of the data portion, and a size of the data portion, determine the third storage address based on the retrieved original storage address of the code portion and the retrieved size of the code portion and determining the fourth storage address based on the retrieved original storage address of the data portion and the retrieved size of the data portion.

Optionally, the description-data configuring module 630 includes: a first configuring sub-module 631 configured to configure a first storage address where the compressed code portion is stored in the electronic device and a second storage address where the compressed data portion is stored in the electronic device, take the first storage address as the first address data, and take the second storage address as the second address data; or configuring an original storage address of the compressed code portion in the electronic device and an original storage address of the compressed data portion in the electronic device, acquiring a size of the compressed code portion and a size of the compressed data portion; taking the original storage address of the compressed code portion and the size of the compressed code portion as the first address data; and taking the original storage address of the compressed data portion and the size of the compressed data portion as the second address data; and a second configuring sub-module 632 configured to configure the first decompression address and the second decompression address.

Optionally, the description-data configuring module 630 also includes: a size acquiring sub-module 633 configured to acquire a size of the code portion and a size of the data portion; and a size storing sub-module 634 configured to store the size of the code portion and the size of the data portion into the first description data.

Optionally, as shown in Fig. 6C, the compressing module 620 includes: a dividing sub-module 621 configured to divide at least one of the code portion and the data portion; a first compressing sub-module 622 configured to, if the code portion is divided into a number *m* segments, compress the *m* segments of the code portion separately, and compress the data portion; a second compressing sub-module 623 configured to, if the data portion is divided into a number *n* segments, compress *the n* segments of the data portion separately, and compress the code portion; and a third compressing sub-module configured 624 to, if the code portion is divided into a number *m* segments and the data portion is divided into a number *n* segments, compressing the *m* segments of the code portion separately, and compressing the *n* segments of the data portion separately.

Accordingly, in the device for compressing a firmware program provided in the embodiment of the present disclosure, the code portion and the data portion of the firmware program are compressed separately; first description data corresponding to the firmware program is configured, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device. Thereby, when it needs to run the firmware program, the electronic device can directly acquire the compressed code portion and the compressed data portion based on the first description data, and respectively decompress the compressed code portion and the compressed data portion to the first decompression address and the second first decompression address. Thus, it can solve the problem in the related art that after the firmware program is decompressed, the electronic device is required to copy the decompressed code portion and data portion, resulting in a complex process. Moreover, it can solve the problem that it is complicated to copy codes and the copy method has poor universality. Therefore, it can achieve an effect of reducing the complexity of the process of the electronic device by eliminating the need to copy codes.

In the present embodiment, the code portion and the data portion of the firmware program are compressed separately, thereby the electronic device can directly decompress the compressed code portion to the first decompression address, and directly decompress the compressed data portion to the second decompression address, rather than decompressing the firmware program as a whole and then copying it to a corresponding decompression address. Thus, it can eliminate the need to reserve a space in the memory of the electronic device to store the decompressed firmware program and can improve the utilization of the space of the memory of the electronic device.

Fig. 7 is a block diagram of a device for decompressing a firmware program according to an exemplary embodiment. As shown in Fig. 7, the device for decompressing a firmware program can include but is not limited to: a description-data retrieving module 710, an acquiring module 720 and a decompressing module 730.

The description-data retrieving module 710 is configured to retrieve first description data corresponding to the firmware program, the first description data containing first address data regarding where a compressed code portion of the firmware program is stored in an electronic device, second address data regarding where a compressed data portion of the firmware program is stored in the electronic device, a first decompression address where the compressed code portion is to be decompressed in the electronic device, and a second decompression address where the compressed data portion is to be decompressed in the electronic device; the acquiring module 720 is configured to acquire the compressed code portion based on the first address data, and acquire the compressed data portion based on the second address data; and the decompressing module 730 is configured to decompress the compressed code portion to the first decompression address, and decompress the compressed data portion to the second decompression address.

Accordingly, in the method for decompressing a firmware program provided in the embodiment of the present disclosure, first description data corresponding to the firmware program is retrieved, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device; the compressed code portion is acquired based on the retrieved first address data, and the compressed data portion is acquired based on the retrieved second address data; the compressed code portion is decompressed to the first decompression address, and the compressed data portion is decompressed to the second decompression address. Thereby, it can solve the problem in the related art that after the firmware program is decompressed, the electronic device is required to copy the decompressed code portion and data portion, resulting in a complex process. Moreover, it can solve the problem that it is complicated to copy codes and the copy method has poor universality. Therefore, it can achieve an effect of reducing the complexity of the process of the electronic device by eliminating the need to copy codes.

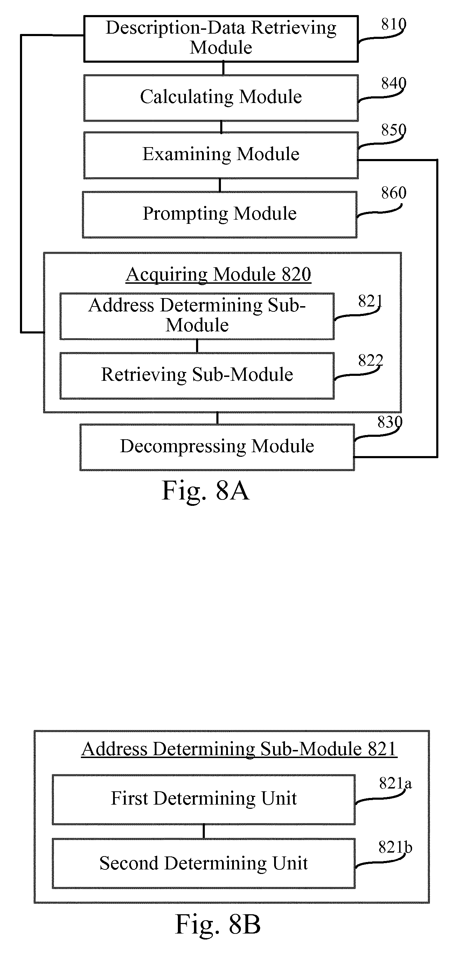

Fig. 8A is a block diagram of a device for decompressing a firmware program according to an exemplary embodiment. As shown in Fig. 8A, the device for decompressing a firmware program can include but is not limited to: a description-data retrieving module 810, an acquiring module 820 and a decompressing module 830.

The description-data retrieving module 810 is configured to retrieve first description data corresponding to the firmware program, the first description data containing first address data regarding where a compressed code portion of the firmware program is stored in an electronic device, second address data regarding where a compressed data portion of the firmware program is stored in the electronic device, a first decompression address where the compressed code portion is to be decompressed in the electronic device, and a second decompression address where the compressed data portion is to be decompressed in the electronic device; the acquiring module 820 is configured to acquire the compressed code portion based on the first address data, and acquire the compressed data portion based on the second address data; and the decompressing module 830 is configured to decompress the compressed code portion to the first decompression address, and decompress the compressed data portion to the second decompression address.

Optionally, the acquiring module 820 includes: an address determining sub-module 821 configured to determine a first storage address based on the first address data and determine a second storage address based on the second address data; and a retrieving sub-module 822 configured to retrieve the compressed code portion from the first storage address and retrieve the compressed data portion from the second storage address.

Optionally, as shown in Fig. 8B, the address determining sub-module 821 includes: a first determining unit 821a configured to, if the first address data is the first storage address and the second address data is the second storage address, determine the first storage address and the second storage address based on the retrieved first description data; and a second determining unit 821b configured to, if the first address data is an original storage address of the compressed code portion and a size of the compressed code portion, and the second address data is an original storage address of the compressed data portion and a size of the compressed data portion, determine the first storage address based on the original storage address and the size of the compressed code portion, and determine the second storage address based on the original storage address and the size of the compressed data portion.

Optionally, the first description data further contains a size of an uncompressed code portion of the firmware program and a size of an uncompressed data portion of the firmware program, and the device further includes: a calculating module 840 configured to calculate a total size of the uncompressed code portion and the uncompressed data portion; an examining module 850 configured to examine whether the total size exceeds a space for running the firmware program in the electronic device; and a prompting module 860 configured to, if the total size exceeds a space for running the firmware program, prompt an error of the firmware program.

Accordingly, in the device for decompressing a firmware program provided in the embodiment of the present disclosure, first description data corresponding to the firmware program is retrieved, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device; the compressed code portion is acquired based on the retrieved first address data, and the compressed data portion is acquired based on the retrieved second address data; the compressed code portion is decompressed to the first decompression address, and the compressed data portion is decompressed to the second decompression address. Thereby, it can solve the problem in the related art that after the firmware program is decompressed, the electronic device is required to copy the decompressed code portion and data portion, resulting in a complex process. Moreover, it can solve the problem that it is complicated to copy codes and the copy method has poor universality. Therefore, it can achieve an effect of reducing the complexity of the process of the electronic device by eliminating the need to copy codes.

In the present embodiment, the code portion and the data portion of the firmware program are compressed separately, thereby the electronic device can directly decompress the compressed code portion to the first decompression address, and directly decompress the compressed data portion to the second decompression address, rather than decompressing the firmware program as a whole and then copying it to a corresponding decompression address. Thus, it can eliminate the need to reserve a space in the memory of the electronic device to store the decompressed firmware program and can improve the utilization of the space of the memory of the electronic device.

With respect to the devices in the above embodiments, the specific manners for performing operations for individual modules therein have been described in detail in the embodiments regarding the relevant methods, which will not be elaborated herein.

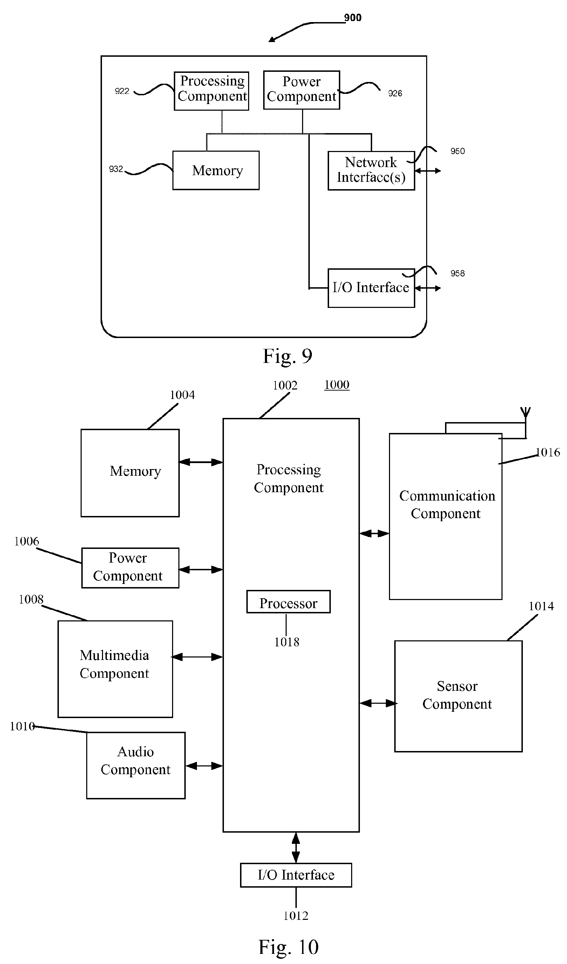

Fig. 9 is a block diagram of a device 900 for compressing a firmware program, according to an exemplary embodiment. For example, the device 900 may be provided as a server. Referring to Fig. 9, the device 900 includes a processing component 922 that further includes one or more processors, and memory resources represented by a memory 932 for storing instructions executable by the processing component 922, such as application programs. The application programs stored in the memory 932 may include one or more modules each corresponding to a set of instructions. Further, the processing component 922 is configured to execute the instructions to perform the above described method for compressing a firmware program.

The device 900 may also include a power component 926 configured to perform power management of the device 900, wired or wireless network interface(s) 950 configured to connect the device 900 to a network, and an input/output (I/O) interface 958. The device 900 may operate based on an operating system stored in the memory 932, such as Windows Server^{™}, Mac OS X^{™}, Unix^{™}, Linux^{™}, FreeBSD^{™}, or the like.

Fig. 10 is a block diagram of a device 1000 for decompressing a firmware program, according to an exemplary embodiment. For example, the device 1000 may be a mobile phone, a computer, a digital broadcast terminal, a messaging device, a gaming console, a tablet, a medical device, exercise equipment, a personal digital assistant, and the like.

Referring to Fig. 10, the device 1000 may include one or more of the following components: a processing component 1002, a memory 1004, a power component 1006, a multimedia component 1008, an audio component 1010, an input/output (I/O) interface 1012, a sensor component 1014, and a communication component 1016.

The processing component 1002 typically controls overall operations of the device 1000, such as the operations associated with display, telephone calls, data communications, camera operations, and recording operations. The processing component 1002 may include one or more processors 1018 to execute instructions to perform all or part of the steps in the above described methods. Moreover, the processing component 1002 may include one or more modules which facilitate the interaction between the processing component 1002 and other components. For instance, the processing component 1002 may include a multimedia module to facilitate the interaction between the multimedia component 1008 and the processing component 1002.

The memory 1004 is configured to store various types of data to support the operation of the device 1000. Examples of such data include instructions for any applications or methods operated on the device 1000, contact data, phonebook data, messages, pictures, video, etc. The memory 1004 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power component 1006 provides power to various components of the device 1000. The power component 1006 may include a power management system, one or more power sources, and any other components associated with the generation, management, and distribution of power in the device 1000.

The multimedia component 1008 includes a screen providing an output interface between the device 1000 and the user. In some embodiments, the screen may include a liquid crystal display (LCD) and a touch panel (TP). If the screen includes the touch panel, the screen may be implemented as a touch screen to receive input signals from the user. The touch panel includes one or more touch sensors to sense touches, swipes, and gestures on the touch panel. The touch sensors may not only sense a boundary of a touch or swipe action, but also sense a period of time and a pressure associated with the touch or swipe action. In some embodiments, the multimedia component 1008 includes a front camera and/or a rear camera. The front camera and the rear camera may receive an external multimedia datum while the device 1000 is in an operation mode, such as a photographing mode or a video mode. Each of the front camera and the rear camera may be a fixed optical lens system or have focus and optical zoom capability.

The audio component 1010 is configured to output and/or input audio signals. For example, the audio component 1010 includes a microphone ("MIC") configured to receive an external audio signal when the device 1000 is in an operation mode, such as a call mode, recording mode, and a voice recognition mode. The received audio signal may be further stored in the memory 1004 or transmitted via the communication component 1016. In some embodiments, the audio component 1010 further includes a speaker to output audio signals.

The I/O interface 1012 provides an interface between the processing component 1002 and peripheral interface modules, such as a keyboard, a click wheel, buttons, and the like. The buttons may include, but are not limited to, a home button, a volume button, a starting button, and a locking button.

The sensor component 1014 includes one or more sensors to provide status assessments of various aspects of the device 1000. For instance, the sensor component 1014 may detect an open/closed status of the device 1000, relative positioning of components, for example the display and the keypad, of the device 1000, a change in position of the device 1000 or a component of the device 1000, a presence or absence of user contact with the device 1000, an orientation or an acceleration/deceleration of the device 1000, and a change in temperature of the device 1000. The sensor component 1014 may include a proximity sensor configured to detect the presence of nearby objects without any physical contact. The sensor component 1014 may also include a light sensor, such as a CMOS or CCD image sensor, for use in imaging applications. In some embodiments, the sensor component 1014 may also include an accelerometer sensor, a gyroscope sensor, a magnetic sensor, a pressure sensor, or a temperature sensor.

The communication component 1016 is configured to facilitate communication, wired or wirelessly, between the device 1000 and other devices. The device 1000 can access a wireless network based on a communication standard, such as WiFi, 2G, or 3G, or a combination thereof. In one exemplary embodiment, the communication component 1016 receives a broadcast signal or broadcast associated information from an external broadcast management system via a broadcast channel. In one exemplary embodiment, the communication component 1016 further includes a near field communication (NFC) module to facilitate short-range communications. For example, the NFC module may be implemented based on a radio frequency identification (RFID) technology, an infrared data association (IrDA) technology, an ultra-wideband (UWB) technology, a Bluetooth (BT) technology, and other technologies.

In exemplary embodiments, the device 1000 may be implemented with one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic components, for performing the above described methods.

In exemplary embodiments, there is also provided a non-transitory computer-readable storage medium including instructions, such as included in the memory 1004, executable by the processor 1018 in the device 1000, for performing the above-described methods. For example, the non-transitory computer-readable storage medium may be a ROM, a RAM, a CD-ROM, a magnetic tape, a floppy disc, an optical data storage device, and the like.

In exemplary embodiments, there is also provided a non-transitory computer-readable storage medium storing instructions, such as stored in the memory 832, executable by the processor 822 in the device 800, for performing the above-described methods. For example, the non-transitory computer-readable storage medium may be a ROM, RAM, a CD-ROM, a magnetic tape, a floppy disc, an optical data storage device, and the like.

Although individual modules and units have been described according to their respective functions, a single module or unit may be used in place of one or more of the modules or units described. The modules or units may be implemented in software, hardware, or a combination thereof.

## Claims

1. A method for decompressing a firmware program, comprising:
retrieving (301) first description data corresponding to the firmware program, the first description data containing first address data regarding where a compressed code portion of the firmware program is stored in an electronic device, second address data regarding where a compressed data portion of the firmware program is stored in the electronic device, a first decompression address where the compressed code portion is to be decompressed in the electronic device, and a second decompression address where the compressed data portion is to be decompressed in the electronic device;
acquiring (302) the compressed code portion based on the first address data, and acquiring the compressed data portion based on the second address data; and
decompressing (303) the compressed code portion to the first decompression address, and decompressing the compressed data portion to the second decompression address.

2. The method of claim 1, wherein acquiring the compressed code portion based on the first address data, and acquiring the compressed data portion based on the second address data comprises:
determining (402) a first storage address based on the first address data and determining a second storage address based on the second address data; and
retrieving (403) the compressed code portion from the first storage address and retrieving the compressed data portion from the second storage address.

3. The method of claim 2, wherein determining a first storage address based on the first address data and determining a second storage address based on the second address data comprises:
if the first address data is the first storage address and the second address data is the second storage address, determining (402a) the first storage address and the second storage address based on the retrieved first description data; and
if the first address data is an original storage address of the compressed code portion and a size of the compressed code portion, and the second address data is an original storage address of the compressed data portion and a size of the compressed data portion, determining (402b) the first storage address based on the original storage address and the size of the compressed code portion, and determining the second storage address based on the original storage address and the size of the compressed data portion.

4. The method of any one of claims 1 to 3, wherein the first description data further contains a size of an uncompressed code portion of the firmware program and a size of an uncompressed data portion of the firmware program, and the method further comprises:
calculating (405) a total size of the uncompressed code portion and the uncompressed data portion;
examining (406) whether the total size exceeds a space for running the firmware program in the electronic device; and
if the total size exceeds a space for running the firmware program, prompting (407) an error of the firmware program.

5. A method for compressing a firmware program, comprising:
acquiring (101) a code portion and a data portion of the firmware program;
compressing (102) the code portion and the data portion separately; and
configuring (103) first description data corresponding to the firmware program, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device.

6. The method of claim 5, wherein acquiring a code portion and a data portion of the firmware program comprises:
determining (201) a third storage address of the code portion and a fourth storage address of the data portion; and
retrieving (202) the code portion based on the third storage address and retrieving the data portion based on the fourth storage address.

7. The method of claim 6, wherein determining (201) the third storage address of the code portion and the fourth storage address of the data portion comprises:
retrieving (201a) second description data corresponding to the firmware program; when the second description data contains the third storage address and the fourth storage address, determining (201b) the third storage address and the fourth storage address from the retrieved second description data; and
when the second description data contains an original storage address of the code portion, a size of the code portion, an original storage address of the data portion, and a size of the data portion, determining (201 c) the third storage address based on the retrieved original storage address of the code portion and the retrieved size of the code portion and determining the fourth storage address based on the retrieved original storage address of the data portion and the retrieved size of the data portion.

8. The method of claim 5, wherein configuring (103) first description data corresponding to the firmware program comprises:
configuring (204a) a first storage address where the compressed code portion is stored in the electronic device and a second storage address where the compressed data portion is stored in the electronic device, taking the first storage address as the first address data, and taking the second storage address as the second address data; or
configuring an original storage address of the compressed code portion in the electronic device and an original storage address of the compressed data portion in the electronic device, acquiring a size of the compressed code portion and a size of the compressed data portion; taking the original storage address of the compressed code portion and the size of the compressed code portion as the first address data; and taking the original storage address of the compressed data portion and the size of the compressed data portion as the second address data; and
configuring (204b) the first decompression address and the second decompression address.

9. The method of any one of claims 5 to 8, wherein configuring first description data corresponding to the firmware program further comprises:
acquiring (204c) a size of the code portion and a size of the data portion; and
storing (204d) the size of the code portion and the size of the data portion into the first description data.

10. The method of any one of claims 5 to 8, wherein compressing the code portion and the data portion separately comprises:
dividing (203a) at least one of the code portion and the data portion;
if the code portion is divided into a number *m* segments, compressing (203b) the *m* segments of the code portion separately, and compressing the data portion;
if the data portion is divided into a number *n* segments, compressing (203c) *the n* segments of the data portion separately, and compressing the code portion; and
if the code portion is divided into a number *m* segments and the data portion is divided into a number *n* segments, compressing (203d) the *m* segments of the code portion separately, and compressing the n segments of the data portion separately.

11. A device for decompressing a firmware program, comprising:
a description-data retrieving module (710) configured to retrieve first description data corresponding to the firmware program, the first description data containing first address data regarding where a compressed code portion of the firmware program is stored in an electronic device, second address data regarding where a compressed data portion of the firmware program is stored in the electronic device, a first decompression address where the compressed code portion is to be decompressed in the electronic device, and a second decompression address where the compressed data portion is to be decompressed in the electronic device;
an acquiring module (720, 820) configured to acquire the compressed code portion based on the first address data, and acquire the compressed data portion based on the second address data; and
a decompressing module (730) configured to decompress the compressed code portion to the first decompression address, and decompress the compressed data portion to the second decompression address.

12. The device of claim 11, wherein the acquiring module (720, 820) comprises:
an address determining sub-module (821) configured to determine a first storage address based on the first address data and determine a second storage address based on the second address data; and
a retrieving sub-module (822) configured to retrieve the compressed code portion from the first storage address and retrieve the compressed data portion from the second storage address.

13. The device of claim 12, wherein the address determining sub-module (821) comprises:
a first determining unit (821a) configured to, if the first address data is the first storage address and the second address data is the second storage address, determine the first storage address and the second storage address based on the retrieved first description data; and
a second determining unit (821b) configured to, if the first address data is an original storage address of the compressed code portion and a size of the compressed code portion, and the second address data is an original storage address of the compressed data portion and a size of the compressed data portion, determine the first storage address based on the original storage address and the size of the compressed code portion, and determine the second storage address based on the original storage address and the size of the compressed data portion.

14. A device for compressing a firmware program, comprising:
an acquiring module (510, 610) configured to acquire a code portion and a data portion of the firmware program;
a compressing module (520, 620) configured to compress the code portion and the data portion separately; and
a description-data configuring module (530, 630) configured to configure first description data corresponding to the firmware program, the first description data containing first address data regarding where the compressed code portion is stored in an electronic device, second address data regarding where the compressed data portion is stored in the electronic device, a first decompression address where the compressed code portion is to be decompressed in the electronic device, and a second decompression address where the compressed data portion is to be decompressed in the electronic device.

15. A computer program comprising instructions which, when executed by a processor (922, 1002, 1018), cause a computer to perform the steps of any one of claims 1 to 10.
